# EUROPEAN PATENT APPLICATION

(11) **EP 2 849 244 A1**
(43) Date of publication of application: **18.03.2015**
(21) Application number: 13184246.0
(22) Date of filing: 13.09.2013
(51) Int. Cl.: H01L 51/52, H01L 51/50, H01L 27/32

(54) **Multicolour light-emitting diode, semiconductor display unit, and methods of manufacturing thereof**

(71) Applicant: Nederlandse Organisatie voor Toegepast -Natuurwetenschappelijk Onderzoek TNO, 2628 VK Delft (NL)
(72) Inventor: Gelinck, Gerwin Hermanus, 2628 VK Delft (NL); van Breemen, Albert Jos Jan Marie, 2628 VK Delft (NL); Blom, Paulus Wilhelmus Maria, 2628 VK Delft (NL)
(74) Representative: Jansen, Cornelis Marinus

(57) **Abstract**

Multicolour light-emitting diode, comprising an anode electrode layer, a cathode electrode layer, and a light-emitting layer in between said electrode layers and in contact therewith, the light-emitting layer comprising a blend of an electroluminescent semiconductor material and a ferro-electric material, and wherein at least one or both of said electrode layer forms a modulatable injection barrier with the electroluminescent semiconductor material, wherein at least one of the anode electrode layer or the cathode electrode layer is comprised of two or more colour selection electrodes, and wherein each of said two or more colour selection electrodes comprises a different conducting material for enabling, in use, emission of light having a colour dependent on the respective electrode powered.

## Description

### Field of the invention

The invention relates to a light-emitting diode, comprising an anode electrode layer, a cathode electrode layer, and a light-emitting layer in between said electrode layers and in contact therewith, the light-emitting layer comprising a blend of an electroluminescent semiconductor material and a ferro-electric material, and wherein at least one or both of said electrode layer forms a modulatable injection barrier with the electroluminescent semiconductor material. The invention further relates to a semiconductor display unit, to a method of manufacturing a light-emitting diode and to use of such a method in a method of manufacturing a semiconductor display device.

The development of flexible display technologies has become increasingly important for a large number of applications. The big promise with flexible displays is not just the performance features but the ability to significantly reduce costs. The leading technology in the development of flexible displays is formed by the organic light-emitting diode (OLED) based displays.

Examples of recent developments in this field are, for example, described by international patent applications WO 2008/143509 and WO 2010/062178. These documents describe light-emitting diodes comprising a light-emitting layer that is comprised of a blend of an electroluminescent semiconductor material and a ferro-electric material. In these light-emitting diodes, semiconductor channels are formed in between the electrode layers, embedded in ferro-electric material. These technologies rely on a modulatable injection barrier between an electrode layer and the semiconductor channels to maintain an "on" or "off" state of the pixel without continuous powering, thereby saving energy.

However, despite ongoing efforts to further improve the design of OLEDs, it has been recognised that OLED displays become only truly useful if they have multicolour capability. To achieve this, use can be made of colour filters, or by direct deposition of three colours: red, green, blue. Both technologies are rather costly.

Other alternatives make use of cavity effects for tuning colours, however, this results in undesired angle dependencies. In another alternative, OLEDs may be stacked upon each other, and driven separately or together such as to achieve multicolour emission. This saves area for each pixel. However, the number of layers remains the same, and this solution is difficult to combine with active matrix driving. A further solution, by careful stack engineering, the colour may shift with applied voltage. However, the effect of this is relatively small and it requires complicated (voltage modulated) driving schemes.

It is an object of the present invention to provide a multicolour flexible display technology that overcomes the disadvantages of prior art methods.

### Summary

The objects defined above are achieved by the present invention in that there is provided a multicolour light-emitting diode, comprising an anode electrode layer, a cathode electrode layer, and a light-emitting layer in between said electrode layers and in contact therewith. The light-emitting layer comprises a blend of an electroluminescent semiconductor material and a ferro-electric material. At least one or both of said electrode layers forms a modulatable injection barrier with the electroluminescent semiconductor material. At least one of the anode electrode layer or the cathode electrode layer is comprised of two or more colour selection electrodes, and each of said two or more colour selection electrodes comprises a different conducting material for enabling, in use, emission of light having a colour dependent on the respective electrode powered.

In the light-emitting diode (LED) of the present invention, the colour of emitted light obtained from the LED is predetermined by proper selection of the conducting material used as electrode material for either or both of the anode or cathode electrode layer. By providing at least one of the electrodes such that it is comprised of colour selection electrodes, wherein the colour selection electrodes are made up of different and carefully selected electrode materials, a multicolour light-emitting diode may be obtained. As will be appreciated operating either one of the colour selection electrodes will provide light of a different colour. Further colours may be obtained by simultaneously operating the colour selection electrodes. Switching techniques such as pulse width modulation, or where possible intensity control, enable to blend the colours in such a manner that many different blended colours may be obtained.

As a result of the flat configuration with a light-emitting layer in between electrode layers, the configuration of the present invention including the colour selection electrodes may suitably be implemented with any kind of electrode configuration. These includes for example an active matrix TFT configuration as well as a passive matrix (cross-bar) configuration for an arrangement of light-emitting diodes in accordance with the present invention implemented as a display unit. As will be appreciated, the light-emitting diode may also be implemented as a single multicolour LED device or an arrangement of multiple LEDs. Moreover, this configuration is particularly useful to be implemented as an OLED, although the invention is not limited thereto.

In accordance with an embodiment, the electroluminescent semiconductor material of the light-emitting layer in a multicolour light-emitting diode in accordance with the invention may be arranged such that it forms a plurality of electroluminescent channels through said ferro-electric material, said electroluminescent channels extending between said electrode layers such as to be in contact therewith. Moreover, in accordance with yet a further embodiment, each of said electroluminescent channels is on one end thereof in contact with a respective one of said colour selection electrodes, and an average channel diameter of said electroluminescent channels is such that it is tuned dependent on the conducting material of the corresponding colour selection electrode for tuning of the colour of emitted light. It has been discovered that the colour of the emitted light is not only dependent on the choice of conductor material (i.e. electrode material) for the colour selection electrodes. In addition, the colour of light obtained is also dependent on the diameter of the channels of the semiconductor material embedded in the ferro-electric material. For smaller channel diameters, the light obtained from the diode is relatively more red-shifted than for a same configuration with larger semiconductor channel diameters. Without being bound by any theory, this is believed to be due to the effect of ferro-electric stray fields on the excited states of the semiconductor near the boundaries with the ferro-electric material. This will be explained in more detail further below in this document. The diameter of the channels itself may be tuned by varying the process conditions when creating and applying the ferroelectric-semiconductor blend, thereby altering the morphology of the blend.

In accordance with a further embodiment, the light-emitting layer of the LED comprises at least a first section and a second section, wherein the first section comprises a blend of a first electroluminescent semiconductor material and said ferro-electric material, and wherein said second section comprises a blend of a second electroluminescent semiconductor material and said ferro-electric material. The colour of the emitted light may further be pre-determined by the selection of the semiconductor material used in the light-emitting layer. As will be appreciated, radiation is emitted by an OLED through exciton decay upon recombination of electrons and holes in the electroluminescent semiconductor material. The frequency of the emitted radiation is dependent on the properties of the semiconductor material, i.e. the energy levels of the valence and conduction bands. Therefore, as in the present embodiment, providing the light-emitting layer having different sections, wherein each section comprises a different semiconductor material, increases the number of colours that may be obtained with a LED of the present invention.

In a preferred variant of the above embodiment each colour selection electrode comprises a first area in contact with said first section of the light-emitting layer, and a second area in contact with said second section of the light-emitting layer. In this embodiment, the light-emitting diode comprises at least four different areas (dependent on the number of colour selection electrodes, and the number of light-emitting layer sections): the first colour selection electrode in contact with the first section of the light-emitting layer, the first colour selection electrode in contact with the second section of the light-emitting layer, the second colour selection electrode in contact with the first section of the light-emitting layer, and the second colour selection electrode in contact with the second section of the light-emitting layer. Each pair of semiconductor material and electrode material of the colour selection electrode will provide a different colour light. Again, these different areas may be switched on and off independently, allowing for endless possibilities in blending of the colours provided.

In addition to providing a multicolour LED, the principles of this invention may advantageously be applied for increasing the colour gamut of a multicolour display. The invention is not limited to any number of colour selection electrodes applied. Although in most embodiments described herein, the LED will be described comprising two colour selection electrodes, this is merely described in this manner such as to explain the invention without unnecessarily complicating the description. The skilled person will appreciate that the invention may be implemented having three, four, five or even more colour selection electrodes if desired. Moreover, also in those embodiments wherein the light-emitting layer is comprised of at least a first and a second section, any desired number of sections may be applied.

The conducting materials for said colour selection electrodes may be carefully selected to obtain a desired colour of light, and may for example be selected from a group comprising: Ag, Au, ITO, ZnO and conducting polymers such as PEDOT:PSS. Moreover, the electroluminescent semiconductor material for the light-emitting layer, or dependent on the embodiment for the first or second section thereof, may be carefully selected to obtain a specific colour of light. For example, the electroluminescent semiconductor material may be an element of a group comprising: polyphenylenes, polyphenylene vinylenes, polyfluorenes, and co-polymers of the aforementioned homo-polymer.

In accordance with a further aspect of the invention, there is provided a semiconductor display unit comprising a pixelated light-emitting element. The pixelated light-emitting element comprises an arrangement of pixels, wherein each pixel comprises a multicolour light-emitting diode in accordance with any of the embodiments as described above. The light-emitting diode of the present invention may advantageously be used to create a display device with multicolour pixels.

In a particular embodiment thereof, the semiconductor display unit comprises an anode electrode arrangement for forming the anode electrode layer of said pixels, and a cathode electrode arrangement for forming the cathode electrode layer of said pixels, wherein the anode electrode layer is formed of a plurality of anode electrode bars, and wherein the cathode electrode layer is formed of a plurality of cathode electrode bars, the anode and cathode electrode bars being transverse to each other, wherein the two or more colour selection electrodes of each pixel are comprised by either or both of said anode or cathode electrode layer, such that within said electrode layer comprising the colour selection electrodes, said colour selection electrodes are formed by adjacent electrode bars. In this manner, an active matrix type display unit may be obtained for independently switching the colour selection electrodes of each pixel such as to display a multicolour picture on a display screen created using the display unit.

In accordance with a further embodiment, wherein the light-emitting layer is comprised of sections, including at least a first and a second section, the first and second section are formed by a first and second section bar, and the first and second section bars are arranged transverse to the colour selection electrodes. As will be appreciated, where the light-emitting layer is comprised of more than two sections, these section bars may advantageously all be arranged transverse to the colour selection electrodes. The transverse arrangement of colour selection electrodes and section bars allows for powering of different areas of each pixel using a matrix configuration.

In accordance with a second aspect of the invention, there is provided a method of manufacturing a light-emitting diode, the method comprising the steps of: providing an anode electrode layer; providing a light-emitting layer comprising a blend of an electroluminescent semiconductor material and a ferro-electric material; and providing a cathode electrode layer; wherein the electrode layers and the light-emitting layer are provided such that the light-emitting layer is arranged in between said electrode layers and in contact therewith; and wherein said electroluminescent semiconductor material and an electrode material of at least one or both of said electrode layers is selected such that said at least one or both electrode layers forms a modulatable injection barrier with the electroluminescent semiconductor material; wherein said method further comprises a step of: selecting, for at least one or both of said electrode layers, the electrode material from a plurality of conducting materials, such as to obtain said light-emitting diode being enabled to provide, in use, light of a desired colour. It has been found that in a device configuration that is based on a light-emitting layer comprised of a blend of electroluminescent semiconductor material and a ferro-electric material, and having non-ohmic contacts between at least one of the electrodes and the semiconductor layer, careful selection of the conductor material for providing the electrode enables to create a light-emitting device of which the light colour is dependent on the selected conductor material and the ferroelectric polarization. This enables to create for example OLED devices in many different colours, and it also enables to create multicolour OLED devices that may be operated such as to provide light of any colour. In view of the relatively simple design of the structure obtained with such a method, this is advantageous over conventional designs that rely for example on the use of colour filters or stacked layers.

In accordance with a specific embodiment of the method, at least one or both of the steps of providing the anode electrode layer or providing the cathode electrode layer, said electrode layer is provided being comprised of two or more colour selection electrodes; wherein said step of selecting the electrode material comprises a step of selecting different conducting materials for providing each of said two or more colour selection electrodes for enabling, in use, selectable emission of light having a colour dependent on the respective electrode powered. This enables to create a multicolour light-emitting device, such as a multicolour OLED.

Moreover, in accordance with a further embodiment, the light-emitting layer is provided such that the electroluminescent semiconductor material in the blend forms a plurality of electroluminescent channels through said ferro¬electric material and extending between the electrode layers such that each electroluminescent channel is in contact with a respective one of said colour selection electrodes. The method in accordance with this embodiment further comprising a step of matching an average channel diameter of said electroluminescent channels with the conducting material of the corresponding colour selection electrode for enabling emission of light of a desired colour. The dependency of the colour of the light emitted by the LED and the diameter of these semiconductor channels will be explained later in this document.

According to a further embodiment of the method, the light-emitting layer is provided having a first section and a second section, further comprising the step of selecting, for providing the first section, a first electroluminescent semiconductor material for use in a first blend comprising the first electroluminescent semiconductor material and said ferro-electric material; and selecting, for providing the second section, a second electroluminescent semiconductor material for use in a second blend comprising the second electroluminescent semiconductor material and said ferro-electric material.

In accordance with a further aspect, the invention relates to a use of a method as described above in a manufacturing method of a semiconductor display unit, the manufacturing method further comprising the steps of: providing a pixelated light-emitting element formed by an arrangement of pixels, wherein each pixel comprises a light-emitting diode, and wherein the light-emitting element is provided by a light-emitting layer arranged in between an anode electrode arrangement and a cathode electrode arrangement; wherein said step of providing said pixelated light-emitting element comprises: providing the anode electrode arrangement for forming an anode electrode layer of said pixels, wherein the anode electrode layer is formed of a plurality of anode electrode bars; and providing the cathode electrode arrangement for forming a cathode electrode layer of said pixels, wherein the cathode electrode layer is formed of a plurality of cathode electrode bars; and selecting, for at least one or both of said electrode layers, the electrode material from a plurality of conducting materials, such as to obtain said light-emitting diode being enabled to provide, in use, light of a desired colour.

### Brief description of the drawings

The invention will be further elucidated by description of some specific embodiments thereof, with reference to the enclosed drawings, wherein:
Figure 1 is a schematic cross section of a light-emitting diode in accordance with the present invention;
Figure 2 is a further schematic drawing of a light-emitting diode of the present invention;
Figure 3 is a further embodiment of a light-emitting diode in accordance with the present invention;
Figure 4 is an enlarged schematic drawing of a semiconductor channel within a ferro-electric material in a light-emitting diode of the present invention;
Figure 5a is a schematic drawing of current injection in an ohmic and non ohmic injection barrier in a light-emitting diode of the present invention;
Figure 5b schematically illustrates a light emission from the ohmic and non-ohmic channels illustrated in figure 5a;
Figure 6 illustrate a spectral analysis graph of light emitted from an LED of the present invention;
Figure 7 schematically illustrates a display unit in accordance with an embodiment of the present invention;
Figure 8 illustrates a display unit in accordance with a further embodiment of the present invention;
Figure 9 illustrates a method of the present invention.

### Detailed description

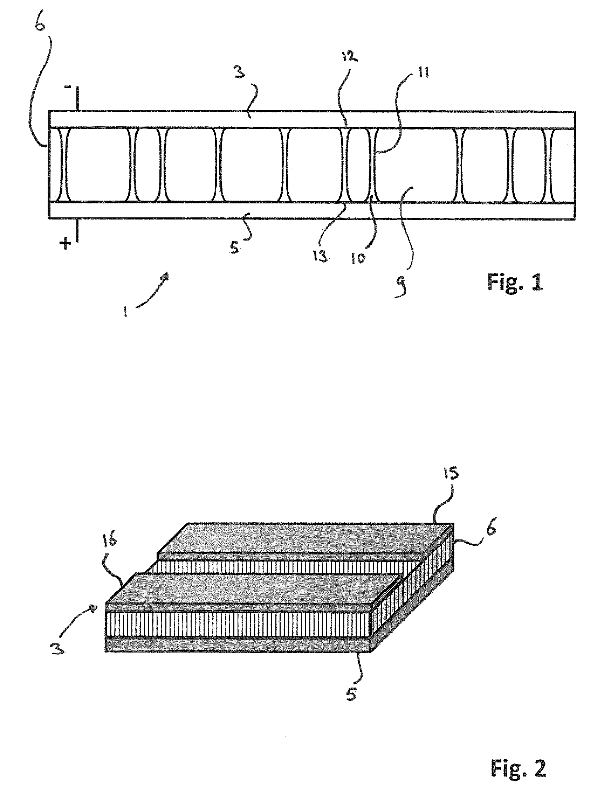

In figure 1, a cross section of a light-emitting diode (LED) in accordance with the present invention is schematically illustrated. The light-emitting diode 1 comprises an anode 3 and a cathode 5. A light-emitting layer is arranged in between the anode 3 and the cathode 5. The light-emitting layer 6 consists of a blend of a ferro-electric material 9 and an electroluminescent semiconductor material 10. The semiconductor material 10 and the ferro-electric material 9 are both of polymeric type. Due to the fact that polymer blends tends to phase separate due to their low enthalpy of mixing and small entropy gain, it is possible to blend an insulating ferro-electric polymer and a light-emitting semiconducting polymer such as to obtain a composite with distinct ferro-electric and semiconducting areas. This behaviour is used to create a layer of ferro-electric polymer material with embedded therein a plurality of semiconducting channels 11 as illustrated in figure 1. The semiconducting channels 11 extend through the light-emitting layer 6 such as to be in contact with the anode 3 and cathode 5. The interface 12 with the anode 3 and the interface 13 with the cathode 5 form the injection barriers for electrons and holes between the channel 11 and each of the electrodes 3 and 5.

At least one of the injection barriers 12 or 13 may be a modulatable injection barrier. The term modulatable injection barrier refers to an injection barrier of which the required energy step for charge injection can be switched from a low to a high level. As a result, when the energy barrier is high, only few charge carriers will be able to enter the semiconductor channel from the electrode. When the energy barrier is in the low level state, charge carriers may easily cross the injection barrier into the semiconductor channel. In other words, in the low energy level state, the resistance provided by the injection barrier is low, and therefore the current through the semiconductor channel 11 will be large. As a result, the intensity of light emitted by the light-emitting diode when the modulatable injection barrier is in the low energy state will be relatively large. In the high energy state of the injection barrier, charge carriers have trouble to cross the injection barrier, i.e. the resistance of the injection barrier is relatively large. As a result only few charge carriers may cross the injection barrier into the semiconductor channel.

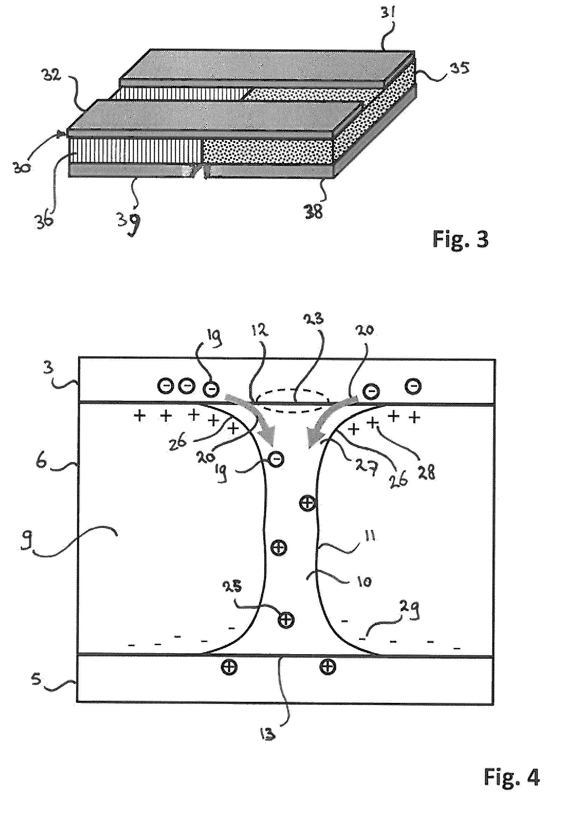

Reference is made to figure 4, wherein an enlarged schematic illustration is provided of semi-conducted channel 11 embedded within ferro-electric material 9. Injection barriers 12 and 13 between each of the electrodes and the semiconductor channel 11 are illustrated in figure 4. In figures 1 and 4, the cathode 3 is made of a conductive material that forms a non-ohmic contact with the semiconductor material 10 within the channel 11. The anode electrode 5 is made of a conductive material that forms an ohmic contact with the semiconductor material 10 of the channel 11. In case a voltage would be applied over the cathode 3 and anode 5 which is not strong enough to polarize the ferro-electric material, current injection may take place across the ohmic injection barrier 13 between the anode and the channel 11, however the non-ohmic injection barrier 12 prevents charge carriers from crossing the barrier thus providing a high resistance. In figure 4, the voltage across cathode 3 and anode 5 is large enough to polarize the ferro-electric material 9. As a result, due to the polarization, stray fields caused by charged accumulation (e.g. in area 28) near the cathode 3 lower the energy gap of the injection barrier 12 near the boundaries with the semiconductor channel 10. Therefore, electrons 19 can cross the injection barrier near the boundaries of the channel 11, as indicated by arrows 20. Influence of the stray fields within the ferro-electric material 9 is limited to the edge of the channel 11. Therefore in the central area indicated generally by reference numeral 23 and the dashed oval, the injection barrier is not influenced. As a result, inflow of charge carriers into the semiconductor material will primarily take place near the edge of the channel.

In particular in the situation illustrated in figure 4, wherein injection barrier 13 is ohmic and injection barrier 12 is modulatable, the inflow of charge through both injection barriers 12 and 13 is unbalanced. In other words, it will be more easy for charge carriers (holes) 25 to cross injection barrier 13 into semiconductor channel 11 than it will be for charge carriers (electrons) 19 to cross injection barrier 12. As a result, recombination of charge carriers 19 and 25 will primarily take place near injection barrier 12, thus near the interface 26 between the ferro-electric material 9 and the semiconductor material 10. This is also the area wherein most influence is experienced from the stray fields caused by charge accumulation (28) within the ferro-electric material 9. It is believed that due to the Stark effect, the shifting and splitting of spectral lines of elements due to the presence of an external electric field, the excited states are shifting and as a result the emitted light is red-shifted as compared to the light that is emitted without these fields. The colour of emitted light is therefore dependent on the selected metal or conductor material of the cathode 3 in the embodiment of figure 4. As a result, by selecting a different conducting material for the electrode that forms the modulatable injection barrier, light of a different colour can be produced in the light-emitting diode of the present invention. This effect may advantageously be used to create a multicolour OLED.

In figure 2, an embodiment of an OLED in accordance with the present invention is schematically illustrated. In the embodiment of figure 2, the light-emitting diode comprises an anode 5, and a light-emitting layer 6. The light-emitting layer is comprised of a blend of a ferro-electric material and an electroluminescent semiconductor material, wherein the semiconductor material forms a plurality of channels that extend through the layer 6 between the cathode 5 and an anode layer 3. Anode layer 3, generally indicated in figure 2, comprises two colour selection electrodes 15 and 16. Each of the colour selection electrodes is constructed from a different conducting material. The conducting material (electrode material) of each of the colour selection electrodes 15 and 16 is carefully selected such as to form non-ohmic contacts with the semiconductor channels. As a result, a light-emitting diode illustrated in figure 2 is able to produce two different colours of light dependent on which colour selection electrode 15 or 16 is powered in combination with the cathode 5.

A further embodiment is illustrated in figure 3. Figure 3 illustrates a light-emitting diode comprising a first anode 38 and a second anode 39. The first anode 38 is in contact with a first section 35 of the light-emitting layer of the diode. The second anode 39 is in contact with a second section 36 of the light-emitting layer of the diode. Transverse to the anodes 38 and 39, colour selection electrodes 31 and 32 are in contact with both the first section 35 and the second section 36 of the light-emitting layer. The first section 35 of the light-emitting layer consists of a blend of a ferro-electric material and a electroluminescent semiconductor material of a first type. The second section 36 consists of a blend of a ferro-electric material and an electroluminescent semiconductor material of a second type. Although in the present embodiment of figure 3 the ferro-electric material in the first section 35 and the second section 36 may be the same ferro-electric material, this is not a requirement of the present invention: the ferro-electric materials of the blend in each of the first and second sections of the light-emitting layer may be different ferro-electric materials. The electrode material of each of the colour selection electrodes 31 and 32 is carefully selected such as to form a non-ohmic contact with the semiconductor material of the first type in the first section 35 and with the semiconductor material of the second type in the second section 36 of the light-emitting layer. Moreover, by means of the ferro-electric material in each section 35 and 36, the injection barriers formed between each of the colour selection electrodes 31 and 32 and each of the sections 35 and 36 becomes modulatable as described above.

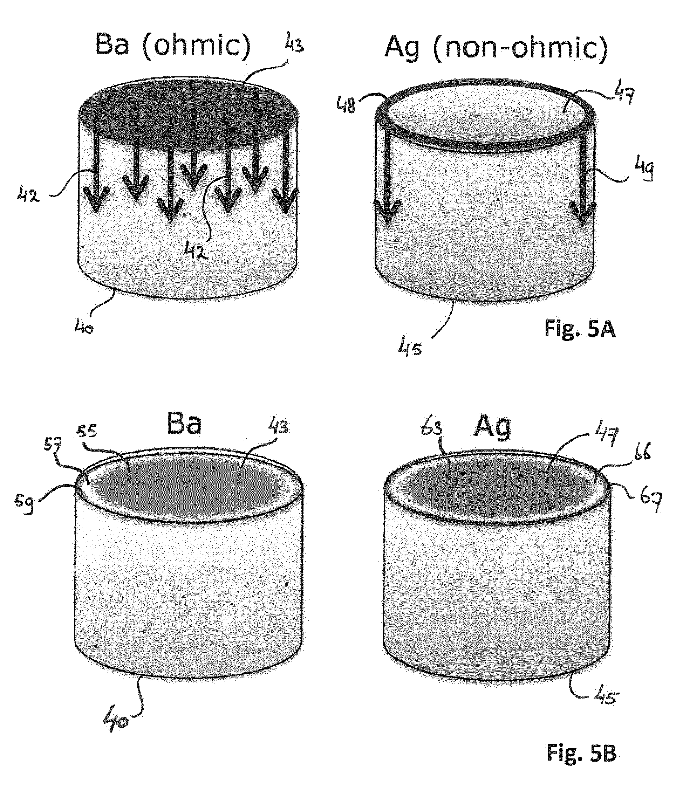

Using the above described configuration of figure 3, the surface of the OLED created thereby comprises four different areas that may be controlled independently. Each of these four areas emit light of a different colour upon powering thereof. The first area is formed by the contact area between the first colour selection electrode 31 and first section 35 of the light-emitting layer. The second area is formed by first colour selection electrode 31 and the second section 36 of the light-emitting layer. The third area is formed by second colour selection electrode 32 and the first section 35 of the light-emitting layer and the fourth area is formed by second colour selection electrode 32 and the second section 36 of the light-emitting layer. In each of the above mentioned areas, a different combination of electrode material in the colour selection electrode and semiconductor material in the respective section on the light-emitting layer will determine the colour of locally emitted light. Therefore, the colour of light emitted from the light-emitting layer will be different from each of these four areas. The splitting of the anode into a first anode 38 and a second anode 39 allows to independently power each of the four areas of the light-emitting diode. In figure 5a, the difference in current injection across the injection barrier of an ohmic and a non-ohmic contact is schematically illustrated. To the left in figure 5a a barium (Ba) electrode forms an ohmic contact with the semiconductor channel 40. The semiconductor channel 40 is formed by F8BT, a semiconducting polymer. The ohmic injection area 43 with the barium electrode allows current injection across the full surface of the injection barrier 43, as indicated by the arrows 42. On the right side in figure 5A the same polymer semiconductor material forms semiconductor channel 45. However, in this case, the electrode is made of silver (Ag) forming a non-ohmic injection barrier 47 with the semiconductor material. Therefore, current injection will only take place near the edge area of the injection barrier 47, indicated by reference numeral 48. The current is schematically indicated with arrows 49.

Figure 5b illustrates the same semiconductor channels 40 and 45 as are indicated in figure 5a. In figure 5b, the light emitted from each of the semiconductor channels is illustrated dependent on where it is produced in the channel. In semiconductor channel 40, most of the light is produced in section 55, the middle section of the semiconductor channel. Part of the light is produced in the concentric area 47 surrounding the middle section 55, and part of the light is produced in the edge area 59. However, in semiconductor channel 45, the middle section 63 of the injection barrier will not (or hardly) produce light due to the fact that current injection through this part of the injection barrier is effectively prevented as indicated in figure 5a. The area 66 surrounding the middle section will produce part of the light, and another part of the light is produced in the edge area 67. However, light from the surrounding area 66 and edge area 67 will be red-shifted due to the presence of the stray fields coming from the ferro-electric material. This is also the case in areas 59 and 57 of channel 40, however since most of the light in channel 40 is produced form the middle section 55, the influence of the red shift on the resulting colour of light perceived is only limited.

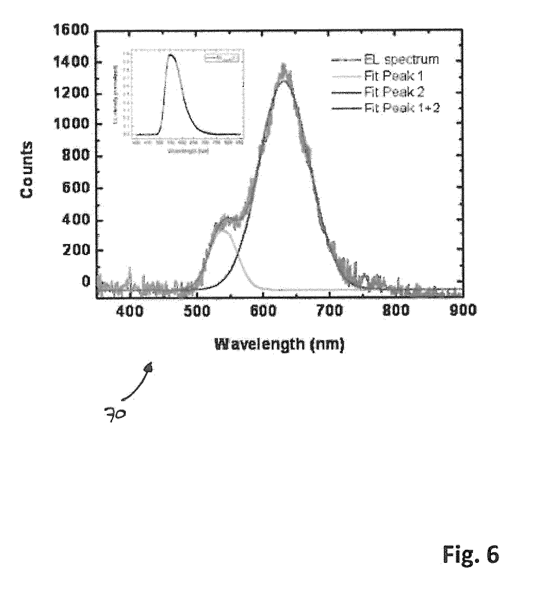

Figure 6 illustrates a spectral analysis from the semiconductor channel 45 in figures 5a and 5b with the silver electrode. In addition to the normal emission of light expected from F8BTS electroluminescence semiconductor polymer, a redshifted peak is clear observed around 540 nanometer.

Due to the fact that in the embodiment of the present invention, light will be primarily produced in the edge area near the interface between the semiconductor material and the ferro-electric and near the electrode, the amount of red shifted light produced in comparison to the normal emission spectrum can be controlled by varying the diameter of the semiconductor channel. Relative influence of the edge area of the channel will be larger with smaller semiconductor channels, and therefore light from smaller diameter channels will be typically more redshifted than light from larger diameter channels. Therefore, by properly selecting the ratio of semiconductor polymer and ferro-electric material in the blend, the diameter of the channels may be controlled and the colour of light produced can be tuned.

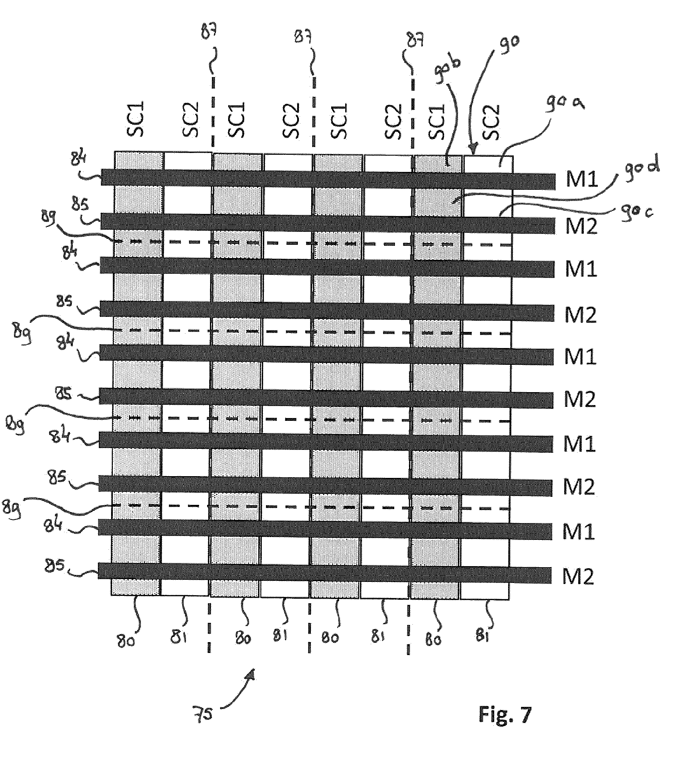

Figure 7 illustrates schematically a semiconductor display unit in accordance with the present invention. The semiconductor display unit 75 is based on the light-emitting diode embodiment illustrated in figure 3. In figure 7, the light-emitting layer consists of a plurality of section bars 80 and 81. Each section bar 80 consists of a blend of a ferro-electric material and a first electroluminescent semiconductor polymer SC1. Each bar 81 consists of ferro-electric material and a second semiconductor polymer SC2.

Transverse to the bars 80 and 81, a plurality of electrode bars 84 and 85 is arranged across the surface of the semiconductor layer. Each electrode bar 84 is comprised of a first conductive material M1 forming non-ohmic and modulatable contacts with the semiconductors SC1 and SC2 in bars 80 and 81. Each electrode bar 85 consists of conductive material M2 that forms non-ohmic and modulatable injection barriers with each of the semiconductor materials SC1 and SC2. Underneath the bars 80 and 81 a plurality of further electrode bars is arranged parallel to the bars 80 and 81 and transverse to the electrodes 84 and 85. The semiconductor display unit 75 thus comprises an active matrix configuration for individually powering a plurality of pixels on the surface of the display unit. A pixel grid is schematically illustrated by dashed lines 87 and 89. Each pixel consists of four areas, as is indicated for pixel 90 in the upper right corner of figure 7.

The pixel 90 consists of areas 90a, 90b, 90c and 90d which are independently powerable. Upon powering either one of the areas 90a-90c, the pixel 90 will provide light of a different colour. It will be appreciated by lighting multiple areas 90a-90d simultaneously, blend colours may be obtained. For this, a pulse with modulated switching scheme may be applied in order to obtain light of many different colours.

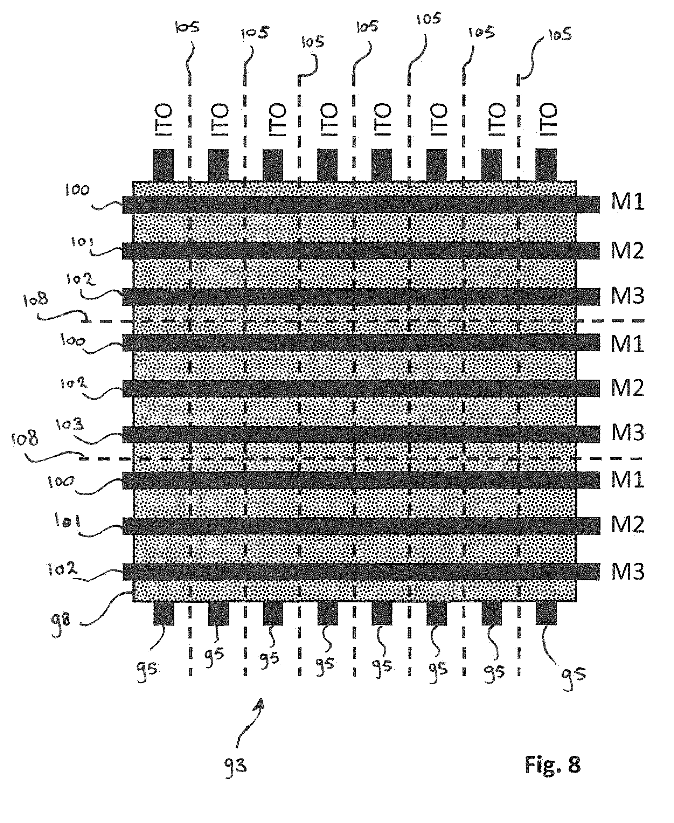

A further embodiment of a semiconductor display unit is illustrated schematically in figure 8. The semiconductor display unit 53 consists of a single light-emitting layer 98 in between electrode arrangements forming the cathode and anode. Underneath light-emitting layer 98 a plurality of ITO electrode bars 95 form the first electrode layer.

On top of the light-emitting layer 98 a plurality of transverse electrode bars (100, 101, 102) forms the second electrode layer. The second electrode layer is formed of consecutive series of three different metal electrodes. Electrode bars 100 consists of a first metal M1, electrode bars 101 consists of a second metal M2 and electrode bars 102 consists of a third metal M3. The metals M1-M3 are carefully selected such as to form non-ohmic and modulatable injection barriers with the semiconductor material present in the blend of light-emitting layer 98. As with the other embodiments of the present invention, the light-emitting layer 98 consists of a blend of ferro-electric material and a suitable electroluminescent semiconductor material. The pixel structure of semiconductor display unit 93 is schematically illustrated by dashed lines 105 and 108. Each pixel is comprised of three areas from which a different colour is obtained. Again, by using a pulse with modulated scheme, the pixels of semiconductor display unit 93 may provide light of many selectable colours.

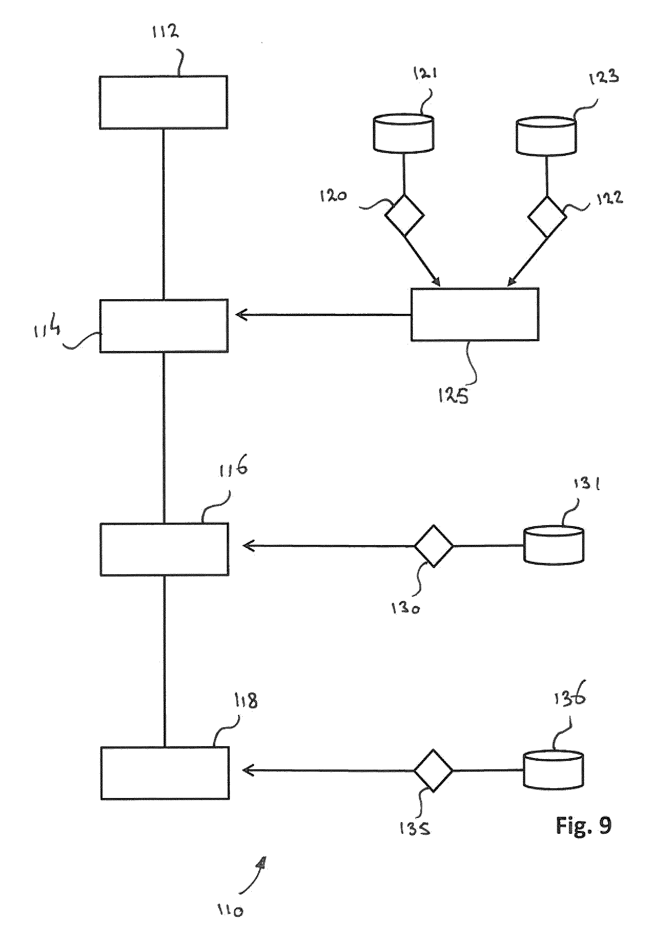

A method in accordance with the present invention is schematically illustrated in figure 9. The method starts with providing a first electrode layer in step 112. The first electrode layer may be comprised of an arrangement of smaller electrodes, as described hereinabove. Then a layer of light-emitting material is provided in step 114. The light-emitting layer provided on to the electrode layer in step 114 consists of a blend of an ferro-electric material and a suitable polymer semiconductor material. For this, a suitable ferro-electric material is selected (step 120) from a repository 121 of known materials. A polymer semiconductor material is selected (step 122) from a repository 123 of known polymer semiconductor materials. The ferro-electric material and the polymer semiconductor material are blended in step 125 and due to their characteristics (low enthalpy of mixing and small entropic gain) will tend to phase separate. The light-emitting layer may be deposited on the electrode layer in step 114 forming the desired semiconductor channels. A proper conductive material will be selected from a repository of known conductive materials 131 in step 130. This conductive material will be used for creating the first colour selection electrodes in step 116. Similar, in step 135 a further conductive material will be selected from a repository 136 for use as second colour selection electrodes. The second colour selection electrodes will be deposited in step 118.

The present invention has been described in terms of some specific embodiments thereof. It will be appreciated that the embodiments shown in the drawings and described here and above are intended for illustrative purposes only, and are not by any manner or means intended to be restrictive on the invention. The context of the invention discussed here is merely restricted by the scope of the appended claims.

## Claims

1. Multicolour light-emitting diode, comprising an anode electrode layer, a cathode electrode layer, and a light-emitting layer in between said electrode layers and in contact therewith, the light-emitting layer comprising a blend of an electroluminescent semiconductor material and a ferro-electric material, and wherein at least one or both of said electrode layer forms a modulatable injection barrier with the electroluminescent semiconductor material, wherein at least one of the anode electrode layer or the cathode electrode layer is comprised of two or more colour selection electrodes, and wherein each of said two or more colour selection electrodes comprises a different conducting material for enabling, in use, emission of light having a colour dependent on the respective electrode powered.

2. Multicolour light-emitting diode in accordance with claim 1, wherein the electroluminescent semiconductor material of the light-emitting layer is arranged such that it forms a plurality of electroluminescent channels through said ferro-electric material, said electroluminescent channels extending between said electrode layers such as to be in contact therewith.

3. Multicolour light-emitting diode in accordance with claim 2, wherein each of said electroluminescent channels is on one end thereof in contact with a respective one of said colour selection electrodes, and wherein an average channel diameter of said electroluminescent channels is such that it is tuned dependent on the conducting material of the corresponding colour selection electrode for tuning of the colour of the emitted light.

4. Multicolour light-emitting diode in accordance with any of the previous claims, wherein the light-emitting layer comprises at least a first section and a second section, wherein the first section comprises a blend of a first electroluminescent semiconductor material and said ferro-electric material, and wherein said second section comprises a blend of a second electroluminescent semiconductor material and said ferro-electric material.

5. Multicolour light-emitting diode in accordance with claim 4, wherein each colour selection electrode comprises a first area in contact with said first section of the light/emitting layer, and a second area in contact with said second section of the light/emitting layer.

6. Multicolour light-emitting diode in accordance with any of the previous claims, wherein the conducting materials for said colour selection electrodes are elements of a group comprising: Ag, Au, ITO, ZnO and conducting polymers such as PEDOT:PSS.

7. Multicolour light-emitting diode in accordance with any of the previous claims, wherein the electroluminescent semiconductor material for the light-emitting layer, or as far as dependent on claim 4 for the first or second section thereof, is an element of a group comprising: polyphenylenes, polyphenylene vinylenes, polyfluorenes, and co-polymers of the aforementioned homo-polymer.

8. Semiconductor display unit comprising a pixelated light-emitting element, said pixelated light-emitting element comprising an arrangement of pixels, wherein each pixel comprises a multicolour light-emitting diode in accordance with one or more of the previous claims.

9. Semiconductor display unit in accordance with claim 8, comprising an anode electrode arrangement for forming the anode electrode layer of said pixels, and a cathode electrode arrangement for forming the cathode electrode layer of said pixels, wherein the anode electrode layer is formed of a plurality of anode electrode bars, and wherein the cathode electrode layer is formed of a plurality of cathode electrode bars, the anode and cathode electrode bars being transverse to each other, wherein the two or more colour selection electrodes of each pixel are comprised by either or both of said anode or cathode electrode layer, such that within said electrode layer comprising the colour selection electrodes, said colour selection electrodes are formed by adjacent electrode bars.

10. Semiconductor display unit in accordance with claim 8 or 9 as far as dependent on claim 4, wherein the first and second section are formed by a first and a second section bar, said first and second section bar being arranged transverse to the colour selection electrodes.

11. Method of manufacturing a light-emitting diode, the method comprising the steps of:
providing an anode electrode layer;
providing a light-emitting layer comprising a blend of an electroluminescent semiconductor material and a ferro-electric material; and
providing a cathode electrode layer;
wherein the electrode layers and the light-emitting layer are provided such that the light-emitting layer is arranged in between said electrode layers and in contact therewith; and
wherein said electroluminescent semiconductor material and an electrode material of at least one or both of said electrode layers is selected such that said at least one or both electrode layers forms a modulatable injection barrier with the electroluminescent semiconductor material;
wherein said method further comprises a step of:
selecting, for at least one or both of said electrode layers, the electrode material from a plurality of conducting materials, such as to obtain said light-emitting diode being enabled to provide, in use, light of a desired colour.

12. Method of manufacturing a light-emitting diode in accordance with claim 11, wherein for said providing of at least one of said anode electrode layer or said cathode electrode layer, said electrode layer is provided being comprised of two or more colour selection electrodes;
wherein said step of selecting the electrode material comprises a step of selecting different conducting materials for providing each of said two or more colour selection electrodes for enabling, in use, selectable emission of light having a colour dependent on the respective electrode powered.

13. Method according to claim 12, wherein the light-emitting layer is provided such that the electroluminescent semiconductor material in the blend forms a plurality of electroluminescent channels through said ferro-electric material and extending between the electrode layers such that each electroluminescent channel is in contact with a respective one of said colour selection electrodes; further comprising a step of:
matching an average channel diameter of said electroluminescent channels with the conducting material of the corresponding colour selection electrode for enabling emission of light of a desired colour.

14. Method according to claim 12 or 13, wherein the light-emitting layer is provided having a first section and a second section, further comprising the steps of:
selecting, for providing the first section, a first electroluminescent semiconductor material for use in a first blend comprising the first electroluminescent semiconductor material and said ferro-electric material; and
selecting, for providing the second section, a second electroluminescent semiconductor material for use in a second blend comprising the second electroluminescent semiconductor material and said ferro-electric material.

15. Use of a method in accordance with any of the claims 11-14 in a method of manufacturing a semiconductor display unit, further comprising the steps of:
providing a pixelated light-emitting element formed by an arrangement of pixels, wherein each pixel comprises a light-emitting diode, and wherein the light-emitting element is provided by a light-emitting layer arranged in between an anode electrode arrangement and a cathode electrode arrangement;
wherein said step of providing said pixelated light-emitting element comprises:
providing the anode electrode arrangement for forming an anode electrode layer of said pixels, wherein the anode electrode layer is formed of a plurality of anode electrode bars; and
providing the cathode electrode arrangement for forming a cathode electrode layer of said pixels, wherein the cathode electrode layer is formed of a plurality of cathode electrode bars; and
selecting, for at least one or both of said electrode layers, the electrode material from a plurality of conducting materials, such as to obtain said light-emitting diode being enabled to provide, in use, light of a desired colour.
